Europäisches Patentamt

European Patent Office

Office européen des brevets

(11) Veröffentlichungsnummer: **0 420 051 A2**

# EUROPÄISCHE PATENTANMELDUNG

(21) Anmeldenummer: 90118138.8

(22) Anmeldetag: 20.09.90

(51) Int. Cl.5: **F26B 5/14, F26B 13/28, F26B 21/00**

(30) Priorität: 28.09.89 DE 3932504

(43) Veröffentlichungstag der Anmeldung:
03.04.91 Patentblatt 91/14

(84) Benannte Vertragsstaaten:
**DE FR GB IT NL**

(71) Anmelder: **Siemens Aktiengesellschaft**
**Wittelsbacherplatz 2**
**W-8000 München 2(DE)**

(72) Erfinder: **Ehrnsperger, Johann**
**Ahornstrasse 10**
**W-8504 Stein(DE)**
Erfinder: **Pörsch, Hans**
**Schwanenweg 5**
**W-8500 Nürnberg 30(DE)**

(54) Verfahren und Anlage zum Trockenblasen von Werkstücken oder Bändern.

(57) Es sollen insbesondere Werkstücke mit Durchbrüchen und/oder wechselnden Rändern von Nässe befreit werden. Dazu werden die Werkstücke oder die Bänder im Durchlauf mit einer laminaren Gasströmung beaufschlagt, durch die die an den Werkstücken anhaftenden Teilchen und/oder in den Durchbrüchen anhaftende Nässe ausgequetscht werden. Bei der zugehörigen Anlage ist einer Transportvorrichtung (5) zum Abtransport der Werkstücke oder der Bänder aus dem Bereich einer Naßreinigung (1) eine Vorrichtung (11, 12; 21,22) zur Erzeugung einer laminaren Gasströmung zugeordnet.

FIG 6

EP 0 420 051 A2

## VERFAHREN UND ANLAGE ZUM TROCKENBLASEN VON WERKSTÜCKEN ODER BÄNDERN

Die Erfindung bezieht sich auf ein Verfahren zum Trockenblasen von ebenen Werkstücken oder Bändern, insbesondere Werkstücken mit Durchbrüchen und/oder wechselnden Rändern. Daneben bezieht sich die Erfindung auch auf die zugehörige Anlage zur Durchführung des Verfahrens, mit einer Transportvorrichtung für Werkstücke und/oder Bänder zum Abtransport aus dem Bereich einer Naßreinigung.

Ebene Werkstücke, wie beispielsweise Blechteile oder auch Elektronikplatinen oder Bänder, die von einem Coil abgezogen werden, werden häufig einer Naßreinigung im Durchlaufverfahren unterzogen. Dabei ist es schwierig, beim Abtransport aus dem Bereich der Naßreinigung die Nässe in der dem Durchlaufverfahren eigenen Wirkzeit, d.h. mit der notwendigen Schnelligkeit, zu entfernen. Für anhaftende Stäube gilt im wesentlichen ähnliches. Insbesondere bei Werkstücken mit vielen kleinen Durchbrüchen besteht das Problem, daß noch Nässe an den Rändern bzw. daran anhaftender Staub mitgeschleppt wird.

Bisher wird bei Werkstücken mit geschlossener Oberfläche ein hinreichendes Trocknungsergebnis durch Abquetschen zwischen Gummiwalzen im Durchlaufverfahren erzielt. Bei Werkstücken mit vielen kleinen Durchbrüchen versagt allerdings die einfache Technologie des Abquetschens, weil die anhaftende Flüssigkeit von den Gummiwalzen in den Durchbrüchen eingesperrt und gleichsam nach dem Prinzip der Zahnradpumpe mittransportiert wird.

Es ist bereits vorgeschlagen worden, durch ein zusätzliches Abblasen mittels bekannter Vielfachdüsen-Anordnungen Abhilfe zu schaffen. Bei Problemwerkstücken mit vielen kleinen Durchbrüchen ergibt sich jedoch kein befriedigender Trocknungserfolg, weil die anhaftenden Nässe-Perlen in der turbulenten Strömung größtenteils nur umverteilt werden.

Aufgabe der Erfindung ist es daher, ein Verfahren und eine zugehörige Vorrichtung anzugeben, mit denen das Trockenblasen von ebenen Werkstücken oder Bändern verbessert wird und insbesondere auch bei Problemwerkstücken ein hinreichend gutes Ergebnis erzielt wird.

Die Aufgabe ist erfindungsgemäß bei einem Verfahren der eingangs genannten Art dadurch gelöst, daß die Werkstücke oder die Bänder im Durchlauf mit einer gegenläufigen, laminaren Gasströmung beaufschlagt werden, durch die an den Werkstücken oder Bändern anhaftende Teilchen und/oder in den Durchbrüchen anhaftende Nässe ausgequetscht werden. Vorteilhafterweise ist die laminare Gasströmung eine Luftströmung und erfolgt die Beaufschlagung mit der Luftströmung gleichmäßig über die gesamte Breite je auf beide Seiten der durchlaufenden Werkstücke oder Bänder.

Bei einer Anlage zur Durchführung des erfindungsgemäßen Verfahrens ist der Transportvorrichtung zum Abtransport der Werkstücke oder der Bänder aus dem Bereich einer Naßreinigung eine Vorrichtung zur Beaufschlagung der Werkstücke oder Bänder mit einer laminaren Gasströmung zugeordnet. Letztere Vorrichtung ist als Schlitzvorrichtung zum Durchlauf der Werkstücke oder Bänder ausgebildet.

Die Schlitzvorrichtung zur Erzeugung einer laminaren Gasströmung kann in einer ersten Ausführungsform der Erfindung durch zwei U-Profile gebildet sein, die beidseitig auf das durchlaufende Werkstück oder Band zustellbar und an eine gemeinsame Druckluftleitung angeschlossen sind. In einer zweiten Ausführungsform der Erfindung kann die Schlitzvorrichtung durch durch separate Schlitzdüsenanordnungen gebildet sein, die jeweils am Einlauf gegenläufig auf das Werkstück oder Band gerichtet und zustellbar sind und separat an Druckluftleitungen angeschlossen sind.

Mit den Schlitzvorrichtungen gemäß der Erfindung ist nunmehr gewährleistet, daß insbesondere ein an Werkstücken oder Bändern anhaftender Nässefilm über die gesamte Anlagenbreite beseitigt, also quasi abgequetscht wird. Durch die Luftströmung wird dabei auch aus den Randbereichen der Durchbrüche die Nässe ausgequetscht bzw. ausgespült. Dabei wird nicht - wie beim Stand der Technik - die Nässe quer zur Durchlaufrichtung von einer Seite des Werkstückes zur anderen durch die Ausnehmungen hindurch abgeblasen, sondern die Nässe wird vielmehr längs zur Transportrichtung und zwar dieser entgegengerichtet entlang der Werkstückoberfläche kontinuierlich verdrängt.

Weitere Vorteile und Einzelheiten der Erfindung ergeben sich aus der nachfolgenden Figurenbeschreibung von Ausführungsbeispielen anhand der Zeichnung in Verbindung mit weiteren Unteransprüchen. Es zeigen

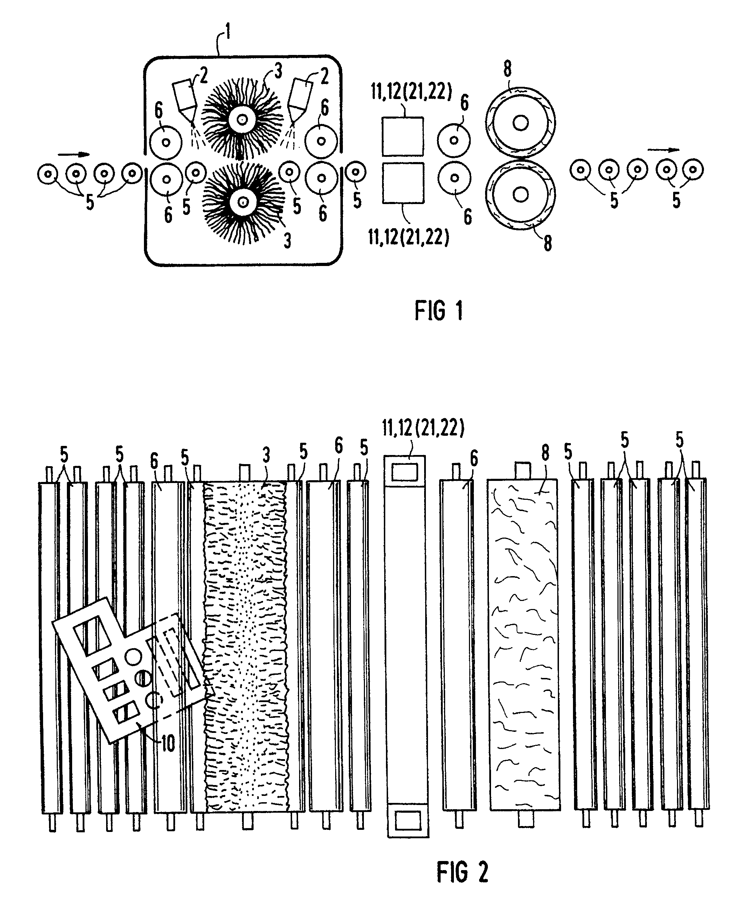

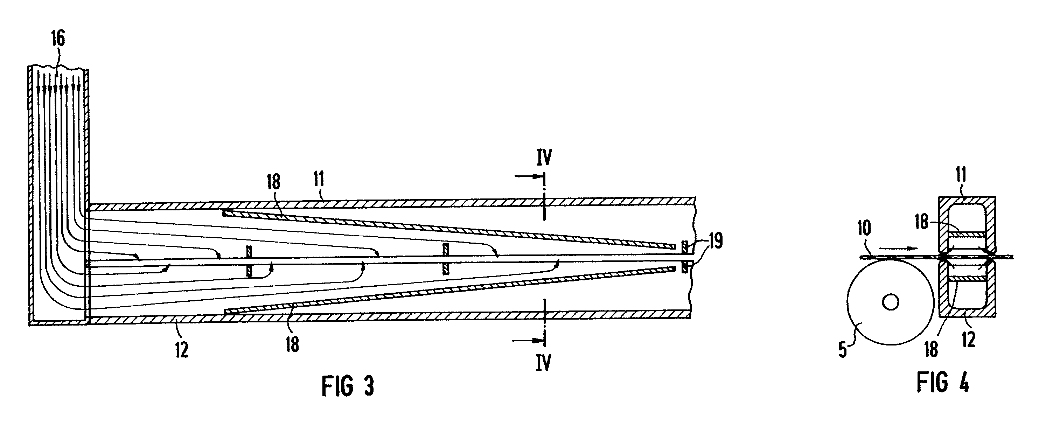

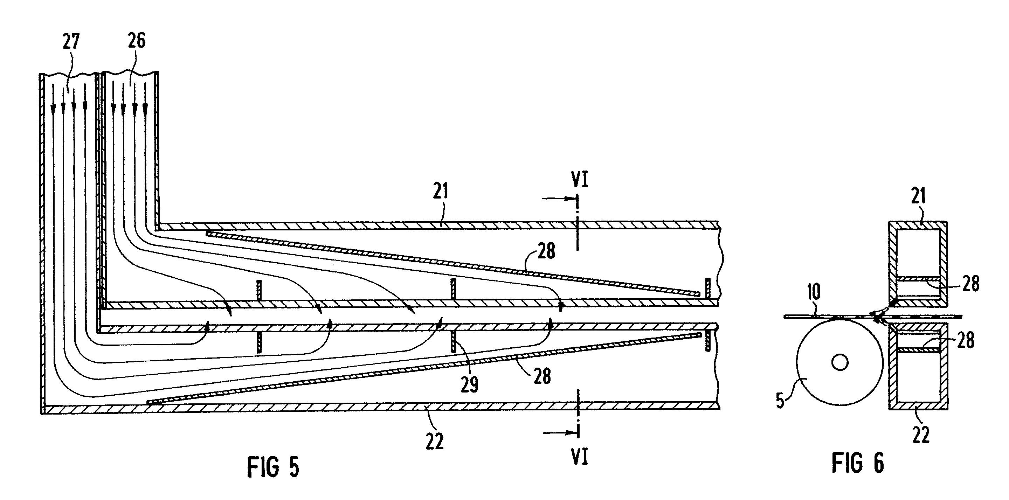

FIG 1 und FIG 2 in schematischer Darstellung den Längsschnitt und die Draufsicht einer Durchlauf-Reinigungsanlage, die von einer erfindungsgemäßen Schlitzvorrichtung Gebrauch macht, FIG 3 eine erste Ausführungsform einer Schlitzvorrichtung im Längsschnitt, wobei nur eine Teilseite dargestellt ist, FIG 4 einen Schnitt durch FIG 3 längs der Linie IV-IV und die Figuren 5 und 6 zwei den Figuren 3 und 4 entsprechende Darstellungen einer zweiten Ausführungsform einer Schlitzvorrichtung.

In FIG 1 und FIG 2 ist eine Reinigungszelle für ebene Werkstücke 10 pauschal mit 1 bezeichnet, die aus einzelnen Spritzdüsen 2 und Reinigungsbürsten 3 besteht. Über Transportwalzen 5 werden die Werkstücke 10 in die Reinigungszelle eingebracht und von dort die nassen Werkstücke 10 in Pfeilrichtung durch die Schlitzanordnung geschoben, auf die weiter unten noch im einzelnen eingegangen wird. Zur korrekten Führung und zum Transport von Werkstücken oder auch Bändern, die von einem Coil abgezogen werden, sind mehrere Führungswalzen 6 vorhanden. Ein Quetschwalzenpaar 8 ist der Schlitzkammer nachgeordnet und dient nur zum Verteilen und Auftrocknen von Restnässe. Dazu wirkt der Belag der Walzen 8 als vergrößerte Trocknungs-Oberfläche.

Eine solche Anlage mit Reinigungszelle 1 und Auftrocknungswalzen 8 ist vom Stand der Technik bekannt und wird durch die nachfolgend beschriebene Schlitzkammer-Anordnung gemäß FIG 3 und FIG 4 bzw. Schlitzdüsen-Anordnung gemäß FIG 5 und FIG 6 als Varianten einer Vorrichtung zur Erzeugung einer laminaren Gasströmung komplettiert. Die Vorrichtungen gemäß FIG 3 bzw. FIG 5 sind dabei symmetrisch zur Mittellinie (Transportrichtung) der Anlage aufgebaut.

In FIG 3 und FIG 4 wird durch zwei mit ihren offenen Seiten zusammengefügte U-Profile bzw. Leisten 11 und 12 eine Kammer gebildet. Diese Anordnung ist der Transportvorrichtung mit Rollen 5, mit der die Werkstücke 10 bzw. Bänder aus dem Bereich der Naßreinigung abtransportiert werden, in Laufrichtung zugeordnet. Die Fügestellen der U-Profile 11 und 12 bilden einen Eingangs- und einen Ausgangsschlitz für die über die Rolle 5 einlaufenden Werkstücke 10. Seitlich ist das Kammergebilde an eine Druckluftleitung 16 angeschlossen. Innerhalb des Kammergebildes sind schräg verlaufende Bleche 18, mit denen der Querschnitt verjüngt wird. Weiterhin können zusätzlich senkrechte Stege 19 vorhanden sein.

Wird das Kammergebilde aus den U-Profilen 11 und 12 gemäß FIG 3 und FIG 4 mit Druckluft beaufschlagt, tritt eine laminare Luftströmung an beiden Schlitzöffnungen aus. Die Luftströmung am Eingangsschlitz hat dabei den Effekt, daß insbesondere anhaftende Nässe verdrängt und das Werkstück getrocknet wird. Der gleiche Effekt tritt bei am Werkstück anhaftenden Stäuben auf.

Bei der Anordnung gemäß FIG 3 und FIG 4 darf die Schlitzweite des Kammergebildes aus den U-Profilen 11 und 11 nicht zu groß sein, da ansonsten das System ineffektiv wird. Insbesondere ist diese Ausführungsform für verhältnismäßig dünne und völlig ebene Werkstücke bis ca. 2 mm Dicke und derartige Bänder, die von einem Coil abgezogen werden, geeignet.

In den Figuren 5 und 6 sind zwei autarke, jeweils in sich geschlossene Kammergebilde 21 und 22 vorhanden. Jede Kammer 21 und 22 hat eine über die gesamte Breite reichende integrierte Schlitzdüse 23 und 24 und zwar eine für die Oberseite und eine für die Unterseite des Werkstückes 10. Seitlich sind die Kammern 21 und 22 an separaten Luftzuführungen 26 und 27 angeschlossen, wodurch sich eine platzsparende Anordnung ergibt.

In den Kammern 21 und 22 sind wieder über die gesamte Breite Bleche 28 zur Querschnittsverjüngung und Querstege 29 zur Führung des Luftstromes vorhanden. Die Stege können hier in der Querrichtung gemäß FIG 6 vorteilhafterweise schräg angeordnet sein und dienen auch zur mechanischen Stabilisierung der Schlitzdüsen-Spalte.

Die Luftströmungen der Düsen 23 und 24 sind derart eingestellt, daß sie sich vor der Rolle 5 in den Ausnehmungen der Werkstücke 10 zu einem gemeinsamen laminaren Luftstrom vereinigen. Der Abstand der Schlitzdüsen 23 und 24 zueinander kann verändert werden und an verschiedene Werkstückdicken angepaßt werden. Dabei ergibt sich ein vergleichsweiser großer Spielraum, da die Strömung durch die Düsen 23 und 24 unabhängig von derem Abstand erzeugt wird.

Die Ausführungsform nach FIG 5 und 6 hat daher einen größeren Anwendungsbereich als die Ausführungsform nach FIG 3 und 4. Beiden Problemlösungen ist gemeinsam, daß die weitgehend laminare Luftströmung längs den Werkstückoberflächen, und zwar an der Oberseite und an der Unterseite, erzwungen ist und auf die Verdrängung von Nässe und/oder Stäuben entgegen der Transportrichtung ausgelegt ist.

## Ansprüche

1. Verfahren zum Trockenblasen von ebenen Werkstücken oder Bändern, insbesondere Werkstücke mit Durchbrüchen und/oder wechselnden Rändern, **dadurch gekennzeichnet**, daß die Werkstücke oder Bänder im Durchlauf mit einer laminaren Gasströmung beaufschlagt werden, durch die an den Werkstücken anhaftende Teilchen und/oder in den Durchbrüchen anhaftende Nässe ausgequetscht werden.

2. Verfahren nach Anspruch 1, **dadurch gekennzeichnet**, daß die laminare Gasströmung eine Luftströmung ist.

3. Verfahren nach Anspruch 1, **dadurch gekennzeichnet**, daß die Beaufschlagung mit der laminaren Gasströmung gleichmäßig über die gesamte Breite der Werkstücke oder Bänder erfolgt.

4. Verfahren nach einem der vorhergehenden Ansprüche, **dadurch gekennzeichnet**, daß die Beaufschlagung mit der laminaren Gasströmung von beiden Seiten der durchlaufenden Werkstücke oder Bänder erfolgt.

5. Anlage zur Durchführung des Verfahrens nach Anspruch 1 oder einem der Ansprüche 2 bis 4, mit einer Transportvorrichtung für Werkstücke und/oder Bänder zum Abtransport aus dem Bereich einer Naßreinigung, **dadurch gekennzeichnet,** daß der Transportvorrichtung (5) eine Vorrichtung (11, 12; 21, 22) zur Beaufschlagung der Werkstücke (10) oder Bänder mit einer weitgehend laminaren Gasströmung zugeordnet ist.

6. Anlage nach Anspuch 5, **dadurch gekennzeichnet,** daß die Vorrichtung (11, 12; 21,22) zur Beaufschlagung der Werkstücke (10) mit einer weitgehend laminaren Gasströmung eine Schlitzvorrichtung zum Durchlauf der Werkstücke (10) oder Bänder ist.

7. Anlage nach Anspruch 6, **dadurch gekennzeichnet,** daß die Schlitzvorrichtung durch zwei U-Profile (11, 12) gebildet ist, die beidseitig auf das durchlaufende Werkstück (10) oder Band zustellbar und an eine gemeinsame Druckluftleitung (16) angeschlossen sind.

8. Anlage nach Anspruch 6, **dadurch gekennzeichnet,** daß die Schlitzvorrichtung durch separate Schlitzdüsenanordnungen (21, 22) gebildet ist, die jeweils am Einlauf gegenläufig auf das Werkstück (10) oder Band gerichtet sowie zustellbar sind und die separat an Druckluftleitungen (26, 27) angeschlossen sind.

9. Anlage nach Anspruch 7 oder Anspruch 8, **dadurch gekennzeichnet,** daß die Druckluftleitungen (16, 26, 27) seitlich an die Schlitzvorrichtung herangeführt sind.

10. Anlage nach Anspruch 7 oder Anspruch 8, **dadurch gekennzeichnet,** daß im Inneren der Schlitzvorrichtung (11, 12; 21, 22) schräge Bleche (18, 28) zur Verjüngung des Querschnittes für die Gasströmung vorhanden sind.

11. Anlage nach Anspruch 7 oder Anspruch 8, **dadurch gekennzeichnet,** daß in der Betriebseinrichtung (11, 12; 21, 22) zusätzliche Stege (19, 29) zur Führung der Gasströmung vorhanden sind.

12. Anlage nach Anspruch 11, **dadurch gekennzeichnet,** daß die Stege (19, 29) einen rechten Winkel zur Querausdehnung der Schlitzvorrichtung (11, 12; 21, 22) bilden.

FIG 1

FIG 2

FIG 3

FIG 4

FIG 5

FIG 6

EP 0 420 051 A2